Europäisches Patentamt

(19) European Patent Office

Office européen des brevets

(11) Publication number: **0 085 777**

A2

(12)

# EUROPEAN PATENT APPLICATION

(21) Application number: **82111734.8**

(22) Date of filing: **17.12.82**

(51) Int. Cl.³: **H 01 L 21/285**
**H 01 L 21/60, H 01 L 21/90**

(30) Priority: **01.02.82 US 344344**

(43) Date of publication of application:
**17.08.83 Bulletin 83/33**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Lau, Chi K.**
**13750 Maham Road No. 2148**
**Dallas Texas(US)**

(74) Representative: **Leiser, Gottfried, Dipl.-Ing. et al,**
**Patentanwälte Prinz, Bunke & Partner Ernsberger**
**Strasse 19**
**D-8000 München 60(DE)**

(54) Fabrication of devices including selective formation of titanium disilicide by direct reaction.

(57) Titanium 3 is deposited on a silicon substrate 1 and on a patterned layer of silicon dioxide 2 or polysilicon, and the structure is heated so that the titanium 3 in contact with silicon 1 or polysilicon reacts to form titanium disilicide 4 ($TiSi_2$), while the titanium in contact with silicon dioxide 2 does not interact. The $TiSi_2$ exhibits a much lower resistivity than silicon or polysilicon. This lower resistivity makes possible further advances in the performance of VLSI devices.

Fig. 3

EP 0 085 777 A2

BACKGROUND OF THE INVENTION

This invention relates to integrated circuit fabrication in general, and more specifically to the formation of titanium disilicide on selected areas.

The use of polysilicon has been a major factor in the progression of integrated circuits to their current levels of performance and packing density. Polysilicon has been used for both gate electrodes and interconnections. However, polysilicon has a serious flaw which may preclude its use in high-performance, high density VLSI applications. That flaw is its resistivity, which is approximately 10 ohms per square. Further advances in the performance of VLSI circuitry would be very difficult at this level of resistivity. The scaling down of VLSI devices requires shallow diffusion regions which result in higher diffusion resistance. This prevents further down-scaling of VLSI devices unless the diffusion resistance can be reduced.

In view of the demand for higher performance in VLSI, the use of metal silicides on polysilicon and on diffusion regions is being implemented. Platinum slicide use is well known, and its use is wide-spread. An example is disclosed by Darley et al in U.S. Patent No. 4,201,997, which is hereby incorporated by reference. However, platinum silicide does not have desirable high-temperature characteristics, and platinum is quite expensive. Titanium disilicide has a resistivity of less than 1 per square, and processing requirements are compatible with standard IC processes. An example of this implementation is described in "Silicides Nudging Out Polysilicon", Electronics, Volume 54, No. 22, pp. 101-102. An implementation such as in this example is very complex and delicate, as an overall layer of $TiSi_2$ must be etched after deposition to form the desired connection pattern.

It is therefore an object of the present invention to provide a method for the formation of titanium disilicide on selected areas of a silicon substrate or on patterned polysilicon.

It is also an object of the present invention to provide a method for the formation of titanium disilicide which is compatible with VLSI fabrication techniques, without adverse effects on previous process steps.

SUMMARY OF THE INVENTION

In accordance with the present invention, there is provided a method for the selective formation of titanium disilicide on silicon or polysilicon by the direct reaction of titanium therewith, followed by selective wet etching. In a preferred embodiment, a substrate of silicon has a patterned layer of silicon dioxide or polysilicon on it. Over the substrate/oxide/polysilicon surface is deposited a layer of titanium. The structure is then subjected to an elevated temperature in an inert atmosphere, the temperature being sufficient to cause a direct reaction between the titanium and silicon. This reaction results in the formation of titanium disilicide. The titanium over the silicon oxide does not react with the oxide, and is easily removed by selective wet etching. The structure is then subjected to an annealing process to achieve the lowest resistivity possible for the titanium disilicide.

This method has several advantages. A most important one is that of selectivity. Since silicide forms only on silicon or polysilicon , selective etching can be used to remove the unreacted metal without affecting the silicide. Also, high temperatures are not required in the process. The highest temperature required is not enough to cause any degradation of any part of the structure.

BRIEF DESCRIPTION OF THE DRAWINGS

Figure 1 is a cross-sectional view of a structure showing the silicon substrate and patterned layers of oxide and polysilicon;

Figure 2 is a cross-sectional view of the structure of Figure 1 showing the added layer of titanium;

Figure 3 is a cross-sectional view of the structure of Figure 2, after the structure heated and a titanium-silicon and titanium-polysilicon reactions take place;

Figure 4 is a cross-sectional view of the structure of Figure 3 after a selective wet etch has removed the unreacted titanium.

DETAILED DESCRIPTION OF THE INVENTION

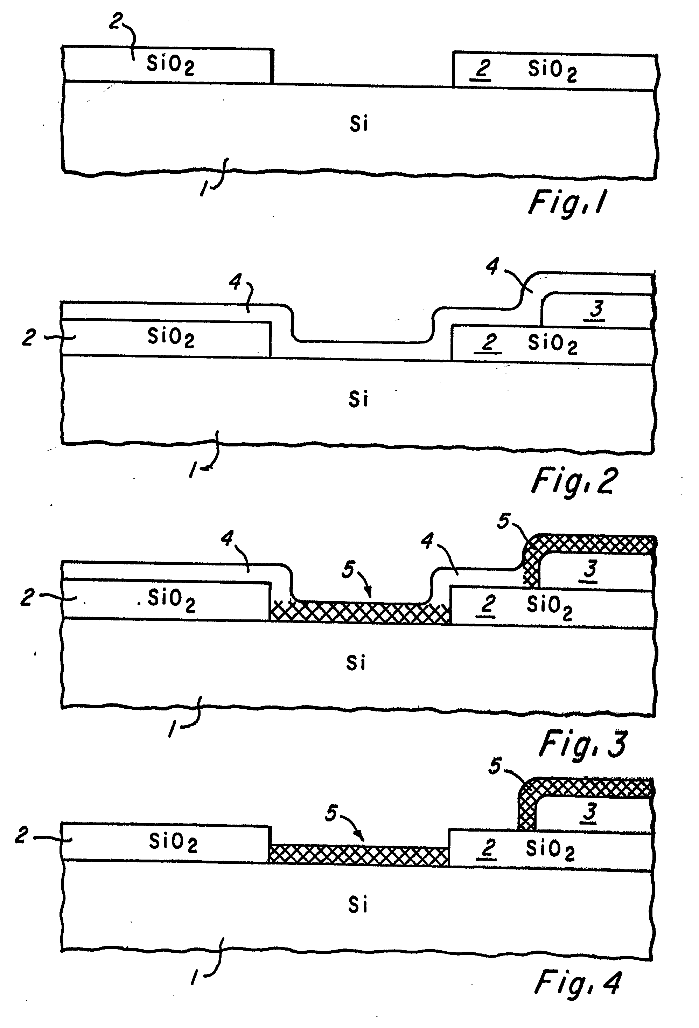

Referring now to Figure 1, there is shown a cross section of a silicon substrate 1 having a patterned layer of silicon dioxide ($SiO_2$) 2 and a patterned layer of polysilicon thereon. The $SiO_2$ layer 2 may be either grown or deposited on the substrate 1 and the polysilicon layer 3 may be deposited on $SiO_2$ layer 2.

In Figure 2, the substrate 1 and patterned oxide and polysilicon layers are covered by depositing a layer of titanium 4. After deposition of the titanium layer, the structure is placed in an inert atmosphere consisting of either an inert gas such as hydrogen or argon, or a vacuum. The structure is heated to a reaction temperature of 600-650° C, care being taken to not allow the temperature to exceed 700° C. The amount of time in the inert, heated environment required for proper reaction of the titanium and silicon/polysilicon is dependent upon the thickness of the deposited titanium layer 4. For example, a layer of titanium of approximately 500 A in thickness over the silicon substrate and patterned oxide would require about 20 minutes exposure for proper reaction. As shown in Figure 3, areas of the titanium which are in contact with the silicon substrate 1 or polysilicon layer 3, react with the silicon in the elevated temperature to form titanium disilicide 5. In the areas where the titanium 4 is in contact with the oxide 2, the titanium does not react with the oxide except at the interface, where a thin (100 A or less) layer of titanium silicate glass compound is formed.

The next step is the removal of the unreacted titanium, and the glass compound at the interface, without damaging the disilicide 5. This is accomplished by a selective wet etching. A suitable etchant comprises $H_2SO_4$ and $H_2O_2$. A preferred mixture consists of approximately 70% $H2SO4$ and 30% $H2O2$. The structure is etched for approximately 5 min. and then appears as is shown in Figue 4. After the etch, the structure is then annealed to achieve the lowest resistivity possible for the disilicide. The annealing is done in temperature at or over 800° C, for a minimum of 30 minutes.

The process described herein possesses several distinct advantages. The selectivity of the process is very signficant. Since the titanium disilicide forms only on silicon or polysilicon surfaces, the silicide is easily patterned as desired. Also, very high temperatures are not required. The 800°C temperature for annealing is the highest required. Additionally, the process is very simple. None of the steps require special equipment or chemicals, and the process is completely compatible with standard integrated circuit processes.

IN THE CLAIMS:

1. A method for selectively forming areas of titanium disilicide on a silicon substrate and on patterned polysilicon , comprising the steps of:

forming and patterning a layer of silicon dioxide on a silicon substrate;

forming and patterning a layer of polysilicon on said layer of silicon dioxide;

depositing a layer of titanium over said patterned layer of oxide and on the exposed areas of said silicon or polysilicon substrate;

heating said structure to cause a reaction in those areas where titanium is in contact with silicon which produces titanium disilicide;

selectively etching said structure to remove titanium from areas where reaction did not occur;

annealing said structure to lower the resistivity of said titanium disilicide.

2. A method as in Claim 1 wherein said forming of silicon dioxide layer comprises depositing silicon dioxide on said silicon substrate.

3. A method as in claim 1 wherein said forming of silicon dioxide layer comprises growing silicon dioxide on said silicon substrate by an oxidation process.

4. A method as in Claim 1, wherein said etching selectively comprises immersion of said structure in a solution of approximately 70% $H_2SO_4$ and 30% $H_2O_2$.

5. A method for fabricating a semiconductor integrated circuit device having a patterned layer of

- 6 -

0085777

titanium disilicide, including the steps as recited in
Claim 1.

6. A method as in Claim 1, wherein said substrate
is an integrated circuit composite substrate.

Fig. 1

Fig. 2

Fig. 3

Fig. 4